# EUROPÄISCHE PATENTSCHRIFT

(11) **EP 3 768 471 B1**
(45) Veröffentlichungstag und Bekanntmachung des Hinweises auf die Patenterteilung: **04.05.2022**
(21) Anmeldenummer: 19717111.9
(22) Anmeldetag: 18.03.2019
(51) Int. Cl.: B25J 9/16, B25J 19/00, B25J 19/06, G01R 31/11

(54) **VERFAHREN ZUR ÜBERWACHUNG EINES VERSORGUNGSSYSTEMS EINES ROBOTERS**
METHOD FOR MONITORING A SUPPLY SYSTEM OF A ROBOT
PROCÉDÉ DE SURVEILLANCE D'UN SYSTÈME D'ALIMENTATION D'UN ROBOT

(30) Priorität: 19.03.2018 DE 102018204184
(43) Veröffentlichungstag der Anmeldung: 27.01.2021
(73) Patentinhaber: BizLink Robotic Solutions Germany GmbH, 98574 Schmalkalden (DE)
(72) Erfinder: HITZ, Bastian, 92353 Postbauer-Heng (DE)
(74) Vertreter: FDST Patentanwälte
(86) Internationale Anmeldenummer: PCT/DE2019/100244
(87) Internationale Veröffentlichungsnummer: WO 2019/179566

(56) Entgegenhaltungen:
- WO-A1-2012/061979
- DE-A1-102016 203 552
- DE-A1-102016 210 601
- DE-U1-202005 005 869
- JP-A- 2017 226 000
- US-B1- 6 853 196

## Beschreibung

Die Erfindung betrifft ein Verfahren zur Überwachung eines Versorgungssystems eines Roboters, welcher einen Roboterarm sowie eine hierzu bewegliche Roboterhand aufweist, wobei das Versorgungssystem ein Versorgungskabel, insbesondere ein Schlauchpaket sowie eine Führung für das Versorgungskabel aufweist, welches zur Versorgung der Roboterhand am Roboterarm entlanggeführt ist.

Aufgrund der Relativbewegung zwischen Roboterarm und Roboterhand ist das Versorgungskabel derart geführt, dass Ausgleichsbewegungen erlaubt sind. Durch die vielfältigen Bewegungen werden unterschiedliche mechanische Belastungen während eines jeweiligen Bearbeitungszyklusses ausgeübt.

Ein Beispiel für eine Vorrichtung zur Führung eines Schlauchpakets entlang eines Roboters ist beispielsweise aus der EP 2 956 277 B1 zu entnehmen.

Neben mechanischen Belastungen ist das Schlauchpaket darüber hinaus auch weiteren Belastungen, beispielsweise thermischen Belastungen oder Medieneinflüssen ausgesetzt. Durch die mannigfaltigen Belastungen ist das Schlauchpaket typischerweise ein Verschleißteil, welches regelmäßig ausgetauscht wird.

Aus der WO 2012/061979 A1 ist ein Verfahren zur Überwachung einer elektrischen Versorgungsleitung beispielsweise bei einem Roboter zu entnehmen, bei dem in die Versorgungsleitung ein Testsignal eingespeist und im Hinblick auf eine Ermüdung der elektrischen Versorgungsleitung ausgewertet wird.

Aus der DE 20 2005 005 869 U1 ist ein Schlauchpaket für einen Roboter mit einem integrierten optischen Überwachungssensor zu entnehmen. Der Überwachungssensor weist eine von einer Ummantelung umgebene claddingfreie Lichtleitfaser auf, so dass bei einer Druckeinwirkung die Ummantelung gegen die Lichtleitfaser gedrückt wird und dadurch eine optische Signalausbreitung innerhalb der Lichtleitfaser beeinflusst wird.

Aus der DE 10 2016 210 601 A1 ist ein Verfahren zur Überwachung einer Leitung einer vorbestimmten Länge zu entnehmen, die einen Messleiter aufweist, in den Messimpulse eingespeist werden. Zur Überwachung der Leitung werden reflektierte Messimpulse mit den eingespeisten Messimpulsen überlagert und in Abhängigkeit der Überlagerung wird eine Abweichung der Laufzeit von einer Soll-Laufzeit erfasst und es wird auf eine Abweichung vom Normalzustand erkannt.

Aus der DE 10 2016 203 552 A1 ist ein Verfahren zur Überwachung einer Versorgungsleitung eines Industrieroboters zu entnehmen, bei dem ein Schutzschlauch auf Verschleiß überwacht wird, indem im Schutzschlauch ein Fluiddruck erzeugt und ausgewertet wird.

Aus der JP 2017 226 000 A ist weiterhin eine optische Überwachung eines Versorgungsstrangs bei einem Roboter zu entnehmen, bei dem auf einem Mantel des Versorgungsstrangs optische Markierungen angebracht sind, welche mit Hilfe eines Kamerasystems ausgewertet werden.

Aus der US 6 853 196 B1 ist ein Verfahren zur Überwachung einer elektrischen Leitung zu entnehmen, bei dem in die Leitung ein Hochvolt-Impuls eingespeist wird, was im Falle einer schadhaften Stelle zu einem elektrischen Zusammenbruch der Leitung führt.

Ausgehend hiervon liegt der Erfindung die Aufgabe zugrunde, die Zuverlässigkeit eines derartigen Schlauchpakets und dessen Einsatzzeit bis zum erforderlichen Austausch zu erhöhen.

Die Aufgabe wird erfindungsgemäß gelöst durch ein Verfahren mit den Merkmalen des Anspruchs 1. Bevorzugte Ausgestaltungen sind in den Unteransprüchen enthalten.

Bei dem Verfahren ist zur Überwachung des Versorgungssystems eines Roboters eine Anzahl von Sensoren zur Überwachung von zumindest einer Zustandsvariablen des Versorgungssystems vorgesehen. Anhand der von dem zumindest einen Sensor ermittelten Werte für die jeweilige Zustandsgröße wird auf die Funktionsfähigkeit des Versorgungssystems zurückgeschlossen. Zweckdienlicherweise wird gleichzeitig eine Aussage über eine noch verbleibende Rest-Lebensdauer getroffen.

Der besondere Vorteil bei diesem System ist darin zu sehen, dass mittels der Sensoren eine aktive Überwachung des aktuellen Zustands, insbesondere verbunden mit einer Vorhersage der Rest-Lebensdauer getroffen wird. Der Versorgungsstrang, insbesondere das Schlauchpaket wird daher nicht mehr zu festen Wartungsintervallen ausgetauscht. Die aufgenommenen Sensordaten werden dabei zweckdienlicherweise abgespeichert und mit einem Zeit-Stempel versehen, um Entwicklungen bei den Werten der Zustandsvariablen oder auch der Eigenschaften des Schlauchpakets nachzuverfolgen und für die Prognose zu berücksichtigen. Speziell können dabei beispielsweise durch Vergleich mit früheren IstWerten Veränderungen oder der Grad der Zunahme von Veränderungen ermittelt werden. Die Sensordaten werden zweckdienlicherweise während des Betriebs kontinuierlich erfasst.

Der Sensor ist dabei unmittelbar im Versorgungsstrang, speziell in einem darin enthaltenen elektrischen Kabel, integriert.

Speziell ist der Sensor dabei als ein Biegesensor ausgebildet, welcher insbesondere die Biegungen des Schlauchpakets oder des Versorgungsstrangs während der Ausgleichsbewegungen erfasst.

Als in das Kabel integrierter Biegesensor wird beispielsweise ein Biegesensor eingesetzt, wie er in der DE 10 2018 204 173 A1 oder in der DE 10 2018 204 171 A1 beschrieben ist.

Das Kabel selbst ist daher als ein intelligentes Kabel ausgebildet, welches zur Überwachung des eigenen Zustands und damit des Versorgungsstrangs herangezogen wird.

Weiterhin weist der Sensor ein im Kabel integriertes Leitungselement auf. Hierbei handelt es sich beispielsweise um eine Ader oder um ein Adernpaar, das im Schlauchpaket geführt ist. In dieses Leitungselement wird ein Sensorsignal mittels einer geeigneten Einspeiseeinheit eingespeist und ein Antwortsignal wird durch eine Auswerteeinheit ausgewertet. Die Einspeiseeinheit und Auswerteeinheit sind dabei typischerweise an der gleiche Seite des Kabels angeordnet. Die Einspeiseeinheit ist beispielsweise in einen Stecker des Kabels integriert oder in einer daran angeschlossenen Versorgungseinheit. Die Auswerteeinheit selbst kann in die Einspeiseeinheit integriert sein oder aber auch entfernt hiervon angeordnet sein. Im letztgenannten Fall wird das Antwortsignal, auch als reflektiertes Signal bezeichnet, an die Auswerteeinheit übermittelt.

Das Antwortsignal entsteht vorzugsweise aufgrund einer Reflexion an einer "Fehlstelle", die beispielsweise durch eine Biegung hervorgerufen ist. Die Ausbreitung des Sensorsignals innerhalb des Leitungselements sowie eine Reflektion von Teilen des Sensorsignals hängt von der Dielektrizität des Leitungselements ab, welche wiederum von den Zustandsvariablen beeinflusst wird. Veränderte Temperaturen, Biegeradien, äußere Drücke beeinflussen das reflektierte Antwortsignal, welches zur Bestimmung des jeweiligen Wertes der Zustandsvariablen ausgewertet wird.

Es wird ein Messverfahren verwendet, wie es in der zum Anmeldezeitpunkt noch unveröffentlichten WO 2018/086949 A1 beschrieben ist.

Hierbei werden im Zuge eines Messzyklus mehrere Einzelmessungen durchgeführt, wobei pro Einzelmessung ein Messsignal von der Einspeiseeinheit in die Sensoradern eingespeist wird, wobei bei einem Überschreiten eines vorgegebenen Spannungs-Schwellwerts (am Einspeiseort) infolge des reflektierten Signalanteils ein Stoppsignal erzeugt wird, wobei eine Laufzeit zwischen dem Einspeisen des Messsignals und dem Stoppsignal ermittelt wird, und wobei der Spannungs-Schwellwert zwischen den Einzelmessungen verändert wird.

Zu jeder Einzelmessung wird daher genau ein Stoppsignal erzeugt. Eine weitergehende Auswertung des reflektierten Signals erfolgt nicht. Aufgrund des zwischen den Einzelmessungen veränderten Schwellwerts werden unterschiedliche Störstellen, welche somit zu unterschiedlich hohen Amplituden bei der Reflektion führen - durch die unterschiedlichen Laufzeiten insbesondere auch örtlich aufgelöst erfasst.

Durch die Vielzahl der Einzelmessungen werden daher allgemein zu unterschiedlichen definierten Schwellwerten die Laufzeiten (Stoppsignale) der reflektierten Anteile erfasst. Insofern kann dieses Verfahren als ein spannungsdiskretes Zeitmessverfahren angesehen werden. Die Zahl der Einzelmessungen liegt dabei bevorzugt über 10, weiter bevorzugt über 20 oder auch über 50 und beispielsweise bis zu 100 oder auch mehr Einzelmessungen. Aus der Vielzahl dieser Einzelmessungen wird also eine Vielzahl von Stoppsignalen ermittelt, die zeitlich verteilt angeordnet sind. Die Vielzahl der Stoppsignale in Verbindung mit den Schwellwerten gibt daher näherungsweise den tatsächlichen Signalverlauf des eingespeisten Messsignals und der reflektierten Anteile wieder. Zweckdienlicher Weise wird aus diesen Stoppsignalen der tatsächliche Signalverlauf für ein eingespeistes und am Leistungsende reflektiertes Messsignal beispielsweise durch einen mathematischen Kurvenfit approximiert.

Eine jeweilige Einzelmessung ist aufgrund des erfindungsgemäßen Messprinzips vorzugsweise beendet, sobald ein Stoppsignal ergangen ist. Um die Leitung auch zuverlässig darauf zu überprüfen, ob mehrere gleichartige Störstellen vorliegen, die jeweils zu einem reflektierten Anteil mit vergleichbarer Signalamplitude führen, wird in bevorzugter Ausgestaltung nach einer ersten Einzelmessung eine Messtotzeit vorgegeben, während derer die Messanordnung quasi deaktiviert ist und nicht auf ein Stoppsignal reagiert. Speziell ist dabei vorgesehen, dass nach einer ersten Einzelmessung und einem erfassten ersten Stoppsignal eine zweite Einzelmessung vorgenommen wird, bei der vorzugsweise der gleiche Schwellwert wie bei der ersten Einzelmessung eingestellt ist. Die Messtotzeit, innerhalb derer keine Erfassung eines Stoppsignals erfolgt, ist dabei (geringfügig) größer als die bei der ersten Einzelmessung erfasste Laufzeit zwischen dem Start- und dem Stoppsignal. Dadurch wird vermieden, dass der dem ersten Stoppsignal zugeordnete reflektierte Anteil bei der zweiten Einzelmessung erfasst wird. Dieser Zyklus wird vorzugsweise mehrfach wiederholt, bis kein weiteres Stoppsignal mehr erfasst wird. Das heißt, die Messtotzeit wird jeweils an die Laufzeit des bei der vorhergehenden Einzelmessung erfassten (ersten, zweiten, dritten etc.) Stoppsignals angepasst, also geringfügig größer gewählt, bis zu diesem eingestellten Schwellwert kein weiteres Stoppsignal mehr ergeht.

Zweckdienlicherweise wird durch geeignete Einstellung der jeweiligen Messtotzeit in Kombination mit einer Variation des Schwellwerts ein Signalverlauf ausgemessen. Insbesondere werden hierdurch auch abfallende Flanken im Signalverlauf erfasst. Signalpeaks mit an- sowie mit abfallenden Flanken lassen sich daher erfassen und auswerten.

Die Führung für das Schlauchpaket weist allgemein ein Ausgleichssystem mit einem beweglichen Führungselement auf. Speziell ist häufig eine Schlauchschelle vorgesehen, an der das Schlauchpaket fixiert ist, und die eine Ausgleichsbewegung relativ zum Roboterarm ausführt. Ein solches Führungselement ist typischer Weise entgegen einer Federkraft / Rückstellkraft beweglich, insbesondere schiebebeweglich gelagert. Zweckdienlicherweise wird nunmehr die Bewegung des Schlauchpakets erfasst und für die Beurteilung der Funktionsfähigkeit des Versorgungssystems, insbesondere des Schlauchpakets herangezogen.

Zweckdienlicherweise werden dabei als Zustandsvariablen die Beschleunigung des Schlauchpakets, die Anzahl der Ausgleichsbewegungen, und/oder die Größe der Ausgleichsbewegung erfasst. Vorzugsweise ergänzend werden parallel hierzu die jeweils aktuellen Umgebungsbedingungen, wie beispielsweise Temperatur, Vibrationen, etc., erfasst und berücksichtigt. All diese Zustandsvariablen werden daher fortlaufend während des Betriebs erfasst und gehen in die Beurteilung der Funktionsfähigkeit und insbesondere bei der Ermittlung der Rest-Lebensdauer ein.

Zweckdienlicherweise wird dabei die Bewegung mittels eines externen Sensors erfasst, welcher in der Führung angeordnet ist. Bei diesem kann es sich um einen elektrischen Sensor, einen optischen Sensor, einen Näherungssensor oder auch um einen Zugsensor an einem Rückholmechanismus für das Ausgleichssystem handeln.

Allgemein ist bevorzugt zusätzlich zu dem im Kabel integrierten Sensor ein externer Sensor angeordnet. Es werden daher Sensordaten sowohl des kabel-internen Sensors als auch des externen Sensors berücksichtigt und ausgewertet, um auf die aktuelle Funktionsfähigkeit des Versorgungssystems zu schließen.

In besonders zweckdienlicher Ausgestaltung wird dabei anhand des Messwerts des externen Sensors ein von dem integrierten Sensor erhaltener Messwert überprüft und verifiziert. Es wird also überprüft, ob die vom kabel-internen Sensor überlieferten Daten plausibel sind. Durch diesen Abgleich mit einem externen Sensor werden beispielsweise Falsch-Diagosen durch den kabel-internen Sensor reduziert. Speziell wird beispielsweise ein im Kabelsensor integrierter Biegesensor und dessen Daten mit den Bewegungsdaten des externen Sensors abgeglichen und verifiziert, ob die Daten plausibel sind.

Für die Auswertung der erhaltenen Daten und Messwerte werden diese in bevorzugter Ausgestaltung mit einem Vergleichssystem verglichen und anhand dieses Vergleichs wird eine Aussage über die Funktionsfähigkeit getroffen. Innerhalb des Vergleichssystems sind Erfahrungswerte, beispielsweise in tabellarischer Form hinterlegt, so dass durch Vergleich mit dem Vergleichssystem aktuelle Zustandsinformationen abgeleitet werden.

Alternativ handelt es sich bei dem Vergleichssystem um ein mathematisches Modell, welches also das reale System nachbildet und mathematisch in Abhängigkeit der variablen Zustandsvariablen beschreibt.

Das Vergleichssystem ist zweckdienlicherweise in einer Auswerteeinheit integriert, an die die Messdaten übermittelt werden. Diese Auswerteeinheit ist beispielsweise in der Maschinensteuerung für den Roboter integriert. Alternativ kann sie jedoch auch in einer übergeordneten Leitstelle oder auch bei einer nicht zum Betreiber des Roboters gehörigen Organisationseinheit enthalten sein. Beispielsweise werden die von den Sensoren enthaltenen Daten an den Hersteller des Schlauchpakets übermittelt, welcher auf diese Weise im Sinne einer Dienstleistung die Funktionsfähigkeit des Versorgungssystems überwacht.

In zweckdienlicher Ausgestaltung werden die Zustandsvariablen in einer Vielzahl von Versorgungssystemen erfasst und an diese übergeordnete, gemeinsame und damit zentrale Auswertestelle und Auswerteeinheit übermittelt. Die gesammelten Daten werden dann für eine Modifizierung des Vergleichssystems herangezogen. Hierdurch ist eine fortlaufende Optimierung und Weiterbildung des Vergleichssystems ermöglicht, um die Aussagegenauigkeit zu verbessern.

Neben dem internen Sensor und dem externen Sensor wird für die Beurteilung der Funktionsfähigkeit bevorzugt weiterhin auch zumindest noch eine weitere, externe Datenquelle, wie z.B. die Maschinensteuerung des Roboters, selbst herangezogen und berücksichtigt. Aus dieser können beispielsweise anhand der Steuerbefehle ebenfalls Bewegungsdaten abgeleitet werden und/oder die Messdaten von den Sensoren werden einer Plausibilitätskontrolle unterzogen.

Gemäß einem weiteren, unabhängigen Aspekt ist ein Verfahren zur Überwachung eines elektrischen Systems vorgesehen, wobei es sich bei dem elektrischen System um ein Daten- und/oder Versorgungssystem handelt, bei dem zumindest zwei Komponenten über ein Kabelsystem miteinander verbunden sind. Dieses elektrische System weist wiederum eine Anzahl an Sensoren auf, über die zumindest eine und vorzugsweise mehrere Zustandsvariablen des elektrischen Systems und/oder der Umgebung erfasst werden. Das Kabelsystem weist dabei ein Kabel mit einem darin integrierten Sensor auf und weiterhin ist ein zusätzlicher externer Sensor außerhalb des Kabelsystems vorgesehen. Ein Messwert dieses externen Sensors wird dann zusätzlich zu dem im Kabel integrierten Sensor ausgewertet, um auf die aktuelle Funktionsfähigkeit des Versorgungssystems zu schließen.

Wie zuvor bereits im Zusammenhang mit dem Roboter erläutert, werden also zur Überprüfung der Funktionsfähigkeit und auch zur Vorhersage der Rest-Lebensdauer daher sowohl ein interner Sensor als auch ein externer Sensor herangezogen. Zweckdienlicherweise wird der externe Sensor dabei insbesondere zur Validierung und Plausibilitätskontrolle der vom internen Sensor übermittelten Daten herangezogen.

Bei dem hier allgemein beanspruchten elektrischen System handelt es sich beispielsweise um ein (Hochvolt-)Versorgungssystem eines Kraftfahrzeugs, speziell eines mit elektrischem Fahrmotor betriebenen Kraftfahrzeugs. Das elektrische System besteht dabei beispielsweise aus einer Batterie, einem Kabel und einer Leistungselektronik / Fahrmotor, wobei die Batterie über das Kabel mit dem Fahrmotor verbunden ist. Alternativ handelt es sich bei dem elektrischen System um ein Wagenübergangssystem, beispielsweise bei schienengebundenen Fahrzeugen, aber auch bei LKWs, etc.. Weiterhin kann es sich auch um eine Ladesystem für die Elektromobilität handeln, bei dem die erste Komponente eine Ladesäule und die zweite Komponente die Batterie ist.

Allgemein wird durch die Einbeziehung der Signale und Informationen von weiteren externen Sensoren die Aussagequalität des Überwachungssystems basierend auf einen in einem Kabel integrierten Sensor verbessert.

Ein Ausführungsbeispiel der Erfindung wird nachfolgend anhand der einzigen Figur näher erläutert. Diese zeigt in einer vereinfachten Darstellung eine Seitenansicht auf einen Industrieroboter.

In der Fig. ist als Roboter ein Gelenkarmroboter dargestellt. Bei diesem Gelenkarmroboter 1 handelt es sich beispielsweise um einen mehrachsigen Industrieroboter, insbesondere um einen sechsachsigen Industrieroboter. Dieser weist eine Basis 8, ein erstes auch als Schwinge 4 bezeichnetes Segment auf, welche mit der Basis 8 über eine erste Gelenkverbindung R1 verbunden ist. Um diese erste Gelenkverbindung R1 ist die Schwinge 4 um eine horizontale Achse verschwenkbar. Ergänzend ist die Schwinge 4 üblicherweise um eine vertikale Achse relativ zur Basis 8 verschwenkbar. Die Schwinge 4 erstreckt sich in etwa in vertikaler Richtung nach oben. An einer zweiten Gelenkverbindung R2 ist ein zweites Segment, allgemein als Roboterarm 2 bezeichnet, um eine so genannte "Achse 3" schwenkbeweglich mit der Schwinge 4 verbunden. Schließlich ist als drittes Segment eine Roboterhand 3 über eine dritte Gelenkverbindung R3 mit dem zweiten Segment 2 verbunden. An der Roboterhand 3 ist schließlich ein Bearbeitungswerkzeug 6, wie beispielsweise eine Schweißzange etc. angebracht. Ein derartiger Industrieroboter 1 weist insgesamt sechs unterschiedliche Bewegungsfreiheitsgrade auf.

Zur Versorgung des Bearbeitungswerkzeugs 6 mit Elektrizität und/oder Fluiden und/oder Datensignalen weist der Industrieroboter 1 einen Versorgungsstrang auf, der nachfolgend als Versorgungsleitungspaket 7 bezeichnet wird. Diese ist am Roboterarm 2 entlanggeführt und von dort mit der Basis 8 verbunden. Im Bereich des Roboterarms 2 ist das Versorgungsleitungspaket 7 zumindest in einem Abschnitt in einem Schutzschlauch geführt. Das Versorgungsleitungspaket 7 gemeinsam mit dem Schutzschlauch wird nachfolgend auch als Schlauchpaket 9 bezeichnet. Häufig ist im Bereich der zweiten Gelenkverbindung eine Trennstelle für das Versorgungsleitungspaket 7 angeordnet und das Schlauchpaket 9 ist als austauschbare Verschleißeinheit bis zu dieser Trennstelle geführt.

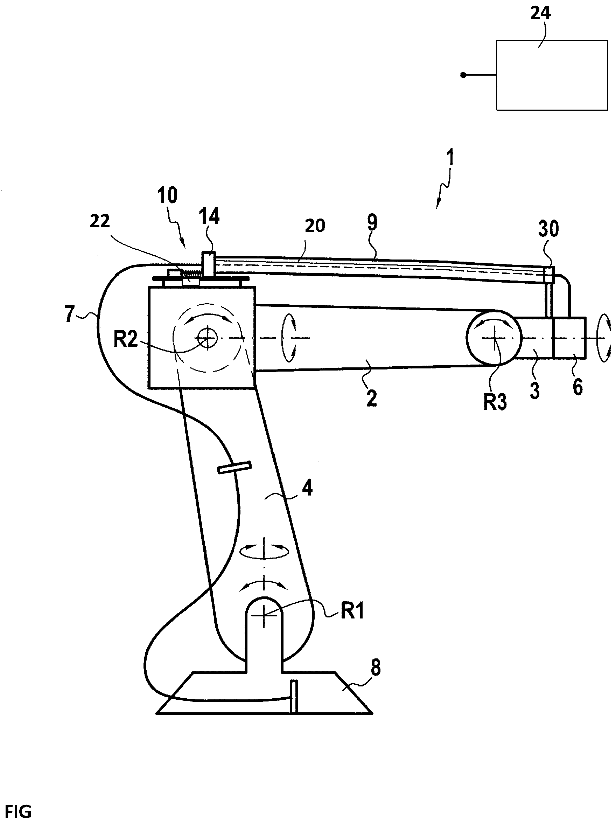

Wie man der Fig. 1 entnehmen kann, wird bei einer Drehbewegung um die dritte Gelenkachse R3 eine Zugbewegung auf das Schlauchpaket ausgeübt. Bei der umgekehrten Bewegung wieder zurück in die Ausgangsposition gemäß der Fig. muss das Schlauchpaket wieder in die Ausgangsposition zurückgezogen werden.

Hierzu ist im Bereich der zweiten Gelenkverbindung R2 auf dem Roboterarm 2 eine Vorrichtung 10 zur Führung und zur Zurückholung des Schlauchpakets 9 befestigt. In der Fig. 1 ist dieses lediglich stark vereinfacht dargestellt. Zu dieser Vorrichtung 10 ist eine Befestigungsschelle 14 gehörig, in der das Schlauchpaket 9 festgehalten ist, insbesondere formschlüssig, sodass eine von der Vorrichtung ausgeübte Rückstellkraft auf das Schlauchpaket 9 übertragen wird. Die Befestigungsschelle 14 ist insbesondere entgegen der Federkraft einer Rückstellfeder (längs-)verschieblich geführt. Im Betrieb führt diese daher mit dem Schlauchpaket Bewegungen aus.

An seinem vorderen, zur Roboterhand 3 orientierten Ende ist das Schlauchpaket 9 zusätzlich über eine weitere Befestigungsschelle 30 fixiert. Die einzelnen Leitungen bzw. das Versorgungsleitungspaket 7 tritt an diesen Positionen aus dem Schutzschlauch aus.

Um nunmehr die Funktionsfähigkeit des Versorgungsleitungspakets und speziell des Schlauchpakets 9 zu überprüfen, weist das Schlauchpaket 9 in integriertes Leitungselement 20 auf, welches einen integrierten Sensor ausbildet. Dieses Leitungselement erstreckt sich dabei in Richtung des Schlauchpakets. Dieses Leitungselement dient speziell zur Erfassung von Biegungen des Schlauchpakets 9.

Ergänzend ist weiterhin ein externer Sensor 22 angeordnet, welcher speziell im Bereich der Vorrichtung 10 angeordnet ist und insbesondere die Bewegungen der Ausgleichsmechanik, beispielsweise die Bewegung der Befestigungsschelle 4 erfasst. Hierbei werden beispielsweise Zugkräfte, Beschleunigungswerte, Geschwindigkeitswerte, Anzahl der Ausgleichsbewegungen, etc., erfasst. Sowohl die Daten des Sensors 20 als auch die des Sensors 22 werden an eine Auswerteeinheit 24 übermittelt und dort ausgewertet, um auf die Funktionsfähigkeit speziell des Schlauchpakets zurückzuschließen. Hierzu ist innerhalb der Auswerteeinheit 24 vorzugsweise ein Vergleichssystem als Abbildung des realen Systems enthalten. Die erhaltenen Messdaten der beiden Sensoren 20, 22 werden mit Hilfe des Vergleichssystems abgeglichen und daraus wird eine aktuelle Zustandsinformation sowie insbesondere ergänzend eine Vorhersage über die Rest-Lebensdauer getroffen.

Während des Betriebs erfolgt eine kontinuierliche Erfassung der relevanten Daten, beispielsweise der Bewegungsdaten mit Hilfe des externen Sensors 22. Diese Daten werden verarbeitet und mit dem Zeitstempel versehen. Die Daten werden dann mit weiteren Informationen, beispielsweise mit denen des internen Sensors 20 oder auch mit weiteren externen Informationen, beispielsweise aus der Maschinensteuerung, abgeglichen und korreliert. Basierend auf dieser Korrelation und Analyse der unterschiedlichen Signale aus der unterschiedlichen Informationsquellen, speziell im Abgleich mit dem Vergleichssystem werden aktuelle Zustandsdaten mit den jeweiligen Lebensdauerprognosen abgegeben.

Die Auswerteeinheit kann dabei in der Maschinensteuerung integriert sein oder alternativ entfernt angeordnet. Die Signale werden beispielsweise drahtlos übermittelt.

Gemäß einer Ausführungsvariante werden beim Erfassen der Daten kritische Zustände, welche beispielsweise einen kritischen Grenzwert überschreiten, als unzulässigen Zustände erfasst und abgespeichert.

Ein Vorteil des hier beschriebenen Systems ist darin zu sehen, dass dieses sich auch für die Nachrüstung zu bestehenden Systemen eignet.

Speziell im Rahmen eines globalen Ansatzes werden hierbei bei einer Vielzahl von eingesetzen Systemen die Daten erfasst und gemeinsam ausgewertet und im Sinne eines lernenden Ansatzes für eine Verbesserung der Auswertung, speziell des Vergleichssystems herangezogen. Das beispielsweise (mathematische) Modell, welches das Vergleichssystem bildet, kann dadurch kontinuierlich verbessert werden. Dabei können auch weitergehende Fehlermeldungen aus den einzelnen installierten Systemen und deren Ausfälle berücksichtigt werden. Ergänzend zu der übergeordneten zentralen Auswerteeinheit ist zweckdienlicherweise für jedes System eine Auswerteeinheit vorgesehen, in dem das Vergleichssystem hinterlegt ist. Diese kann dann zentral upgedatet werden.

## Patentansprüche

1. Verfahren zur Überwachung eines Versorgungssystems eines Roboters, welcher einen Roboterarm (2) sowie eine hierzu bewegliche Roboterhand (3) aufweist, wobei das Versorgungssystem einen Versorgungsstrang (7), insbesondere ein Schlauchpaket sowie eine Führung für den Versorgungsstrang aufweist und der Versorgungsstrang zur Versorgung der Roboterhand am Roboterarm entlanggeführt ist, wobei das Versorgungssystem weiterhin zumindest ein Sensor (20,22) zur Überwachung von zumindest einer Zustandsvariablen des Versorgungssystems aufweist, wobei anhand der vom Sensor ermittelten Werte für die Zustandsvariable auf die Funktionsfähigkeit des Versorgungssystems zurückgeschlosssen wird, wobei der Versorungsstrang ein elektrisches Kabel aufweist und der Sensor im elektrischen Kabel integriert ist und der Sensor durch ein Leitungselement (20) des Kabels gebildet ist, in das ein Sensorsignal eingespeist wird und ein Antwortsignal ausgewertet wird, wobei im Zuge eines Messzyklus mehrere Einzelmessungen durchgeführt werden, wobei
- pro Einzelmessung das Messsignal in das Leitungselement eingespeist wird,
- bei einem Überschreiten eines vorgegebenen Schwellwerts infolge des reflektierten Messsignalanteils ein Stoppsignal erzeugt wird und die Einzelmessung insbesondere beendet wird,
- eine Laufzeit zwischen dem Einspeisen des Messsignals und dem Stoppsignal ermittelt wird.

2. Verfahren nach Anspruch 1, wobei der Sensor als Biegesensor ausgebildet ist.

3. Verfahren nach Anspruch 1 oder 2,
wobei der Schwellwert zwischen den Einzelmessungen verändert wird.

4. Verfahren nach einem der Ansprüche 1 bis 3, wobei nach Erfassung eines ersten Stoppsignals bei einer ersten Einzelmessung eine zweite Einzelmessung mit vorzugsweise dem gleichen Schwellwert wie bei der ersten Einzelmessung vorgenommen wird, wobei bei der zweiten Einzelmessung eine Messtotzeit vorgegeben wird, die größer ist als die bei der ersten Einzelmessung erfasste Laufzeit für das erste Stoppsignal, so dass der dem ersten Stoppsignal zugeordnete reflektierte Anteil bei der zweiten Einzelmessung nicht erfasst wird.

5. Verfahren nach einem der Ansprüche 1 bis 4, bei dem die Führung ein Ausgleichssystem aufweist, welches mit dem Versorgungsstrang verbunden ist, wobei die Bewegung des Versorgungsstrangs erfasst wird und für die Beurteilung der Funktionsfähigkeit des Versorgungssystems herangezogen wird.

6. Verfahren nach Anspruch 5, bei dem wahlweise oder in Kombination die Beschleunigung des Versorgungsstrangs, die Anzahl der Ausgleichsbewegungen oder die Größe der Auslenkung erfasst wird.

7. Verfahren nach Anspruch 5 oder 6, bei dem die Bewegung mittels eines externen Sensors (22) erfasst wird, der in oder an der Führung angeordnet ist

8. Verfahren nach einem der Ansprüche 1 bis 7, bei dem zusätzlich zu dem im Kabel integrierten Sensor (20) ein externer Sensor (22) außerhalb des Kabels angeordnet ist und ein Messwert des externen Sensors zusätzlich zu dem vom im Kabel integrierten Sensor ausgewertet wird, um auf die aktuelle Funktionsfähigkeit des Versorgungssystems zu schließen.

9. Verfahren nach Anspruch 8, bei dem anhand des Messwerts des externen Sensors ein von dem integrierten Sensor erhaltener Messwert als i.O. oder nicht i.O. klassifiziert wird.

10. Verfahren nach einem der Ansprüche 1 bis 9, bei dem die ermittelten Messwerte für die Zustandsvariablen mit einem Vergleichssystem verglichen und daraus eine Aussage über die Funktionsfähigkeit getroffen wird.

11. Verfahren nach Anspruch 10, bei dem die Zustandsvariablen einer Vielzahl von Versorgungssystemen erfasst, an eine übergeordnete gemeinsame zentrale Auswertestelle übermittelt und für eine Modifizierung des Vergleichssystems herangezogen werden.

12. Verfahren nach einem der Ansprüche 1 bis 11, bei dem für die Beurteilung der Funktionsfähigkeit zumindest eine weitere Datenquelle, wie z.B. eine Maschinensteuerung des Roboters, herangezogen und berücksichtigt wird.

## Claims

1. Method for monitoring a supply system of a robot, which robot has a robot arm (2) and a robot hand (3), which can be moved with respect thereto, wherein the supply system has a supply line (7), in particular a hose assembly and a guide for the supply line and the supply line is guided along the robot arm in order to supply the robot hand, wherein the supply system furthermore has at least one sensor (20, 22) for monitoring at least one state variable of the supply system, wherein, based on the values detected by the sensor for the state variable, it is concluded on the functionality of the supply system, wherein the supply line has an electrical cable and the sensor is integrated in the electrical cable and the sensor is formed by a line element (20) of the cable, into which a sensor signal is fed and a response signal is evaluated, wherein a plurality of individual measurements is carried out in the course of a measurement cycle, wherein
- the measurement signal is fed into the line element per individual measurement,
- a stop signal is generated and the individual measurement is in particular ended when a predefined threshold value is exceeded as a result of the reflected measurement signal component,
- a transit time between the feeding of the measuring signal and the stop signal is determined.

2. Method according to claim 1, wherein the sensor is designed as a bend sensor.

3. Method according to claim 1 or 2, wherein the threshold value is changed between the individual measurements.

4. Method according to one of claims 1 to 3, wherein, after detection of a first stop signal in a first individual measurement, a second individual measurement is carried out with preferably the same threshold value as in the first individual measurement, wherein in the second individual measurement a measurement dead time is specified, which is greater than the transit time for the first stop signal detected in the first individual measurement, such that the reflected component associated with the first stop signal is not detected in the second individual measurement.

5. Method according to one of claims 1 to 4, in which the guide has a compensation system, which is connected to the supply line, wherein the movement of the supply line is detected and used to assess the functionality of the supply system.

6. Method according to claim 5, in which optionally or in combination the acceleration of the supply line, the number of compensating movements or the magnitude of the deflection is detected.

7. Method according to claim 5 or 6, in which the movement is detected by means of an external sensor (22) arranged in or on the guide.

8. Method according to one of claims 1 to 7, in which an external sensor (22) is arranged outside the cable in addition to the sensor (20) integrated in the cable, and a measured value of the external sensor is evaluated in addition to that from the sensor integrated in the cable to conclude as to the current functionality of the supply system.

9. Method according to claim 8, in which a measured value obtained from the integrated sensor is classified as correct or incorrect based on the measured value of the external sensor.

10. Method according to one of claims 1 to 9, in which the determined measured values for the state variables are compared with a comparison system and a statement about the functionality is made therefrom.

11. Method according to claim 10, in which the state variables of a multiplicity of supply systems are detected, transmitted to a superordinate common central evaluation point, and used to modify the comparison system.

12. Method according to one of claims 1 to 11, in which at least one further data source such as, for example, a machine controller of the robot, is used and taken into consideration for the assessment of the functionality.

## Revendications

1. Procédé de surveillance d'un système d'alimentation d'un robot, lequel robot comprend un bras de robot (2) ainsi qu'une main de robot (3) mobile par rapport à celui-ci, dans lequel le système d'alimentation comprend une cordon d'alimentation (7), en particulier un ensemble de tuyaux flexibles ainsi qu'un guidage pour le cordon d'alimentation et le cordon d'alimentation est guidée le long du bras de robot pour l'alimentation de la main de robot, dans lequel le système d'alimentation comprend en outre au moins un capteur (20, 22) pour la surveillance d'au moins une variable d'état du système d'alimentation, dans lequel, sur la base des valeurs détectées par le capteur pour la variable d'état, il est conclu à la fonctionnalité du système d'alimentation, dans lequel le cordon d'alimentation comprend un câble électrique et le capteur est intégré dans le câble électrique et le capteur est formé par un élément conducteur (20) du câble, dans lequel un signal de capteur est injecté et un signal de réponse est évalué, dans lequel une pluralité de mesures individuelles sont effectuées au cours d'un cycle de mesure, dans lequel
- par mesure individuelle, le signal de mesure est injecté dans l'élément de ligne,
- un signal d'arrêt est généré et la mesure individuelle est notamment terminée lorsqu'une valeur seuil prédéfinie est dépassée en raison de la composante de signal de mesure réfléchie,
- un temps de transit entre l'injection du signal de mesure et le signal d'arrêt est déterminé.

2. Procédé selon la revendication 1, dans lequel le capteur est conçu comme un capteur d'incurvation.

3. Procédé selon la revendication 1 ou 2, dans lequel la valeur seuil est modifiée entre les mesures individuelles.

4. Procédé selon l'une des revendications 1 à 3, dans lequel, après détection d'un premier signal d'arrêt lors d'une première mesure individuelle, une deuxième mesure individuelle est effectuée avec de préférence la même valeur de seuil que lors de la première mesure individuelle, dans lequel, lors de la deuxième mesure individuelle, un temps mort de mesure est prédéterminé, qui est supérieur au temps de transit pour le premier signal d'arrêt détecté lors de la première mesure individuelle, de sorte que la composante réfléchie associée au premier signal d'arrêt n'est pas détectée lors de la deuxième mesure individuelle.

5. Procédé selon l'une des revendications 1 à 4, dans lequel le guide comprend un système de compensation relié au cordon d'alimentation, dans lequel le mouvement du cordon d'alimentation est détecté et utilisé pour évaluer la fonctionnalité du système d'alimentation.

6. Procédé selon la revendication 5, dans lequel, au choix ou en combinaison, l'accélération du cordon d'alimentation, le nombre de mouvements de compensation ou l'amplitude de la déviation sont détectés.

7. Procédé selon la revendication 5 ou 6, dans lequel le mouvement est détecté au moyen d'un capteur externe (22), qui est disposé dans ou sur le guide.

8. Procédé selon l'une des revendications 1 à 7, dans lequel, en plus du capteur (20) intégré dans le câble, un capteur externe (22) est disposé à l'extérieur du câble et une valeur de mesure du capteur externe est évaluée en plus de celle du capteur intégré dans le câble, afin de conclure à la fonctionnalité actuelle du système d'alimentation.

9. Procédé selon la revendication 8, dans lequel sur la base de la valeur de mesure du capteur externe une valeur de mesure obtenue par le capteur intégré est classée comme étant OK ou non OK.

10. Procédé selon l'une des revendications 1 à 9, dans lequel les valeurs de mesure déterminées pour les variables d'état sont comparées à un système de comparaison et une conclusion est tirée de cette comparaison quant à la fonctionnalité.

11. Procédé selon la revendication 10, dans lequel les variables d'état d'une multitude de systèmes d'alimentation sont détectées, transmises à un service d'évaluation central commun supérieur et utilisées pour une modification du système de comparaison.

12. Procédé selon l'une des revendications 1 à 11, dans lequel au moins une autre source de données comme, par exemple, une commande de machine du robot, est utilisée et prise en compte pour l'évaluation de la fonctionnalité.
